# EUROPEAN PATENT SPECIFICATION

(11) **EP 2 135 239 B1**
(45) Date of publication and mention of the grant of the patent: **31.07.2013**
(21) Application number: 08723216.1
(22) Date of filing: 29.02.2008
(51) Int. Cl.: G10L 19/032

(54) **METHOD AND APPARATUS FOR CODING AND DECODING AMPLITUDE OF PARTIAL**
VERFAHREN UND VORRICHTUNG ZUM CODIEREN UND DECODIEREN EINER PARTIAL-AMPLITUDE
PROCÉDÉ ET APPAREIL DE CODAGE ET DE DÉCODAGE D'AMPLITUDE DE PARTIELS

(30) Priority: 12.04.2007 KR 20070036175
(43) Date of publication of application: 23.12.2009
(73) Proprietor: Samsung Electronics Co., Ltd., Suwon-si, Gyeonggi-do, 443-742 (KR)
(72) Inventor: LEE, Nam-Suk, Suwon-si Gyeonggi-do 443-739 (KR); LEE, Geon-Hyoung, Hwaseong-si Gyeonggi-do 445-990 (KR); OH, Jae-One, Yongin-si Gyeonggi-do 446-752 (KR); LEE, Chul-Woo, Suwon-si Gyeonggi-do 443-802 (KR); JEONG, Jong-Hoon, Suwon-si Gyeonggi-do 443-755 (KR)
(74) Representative: Robinson, Ian Michael
(86) International application number: PCT/KR2008/001178
(87) International publication number: WO 2008/126984

(56) References cited:
- KR-A- 20050 058 262
- KR-A- 20060 083 202
- EDLER B ET AL: "ASAC - ANALYSIS/SYNTHESIS AUDIO CODEC FOR VERY LOW BIT RATES", PREPRINTS OF PAPERS PRESENTED AT THE AES CONVENTION, XX, XX, 11 May 1996 (1996-05-11), pages 1-15, XP001062332,
- PIM KORTEN ET AL: "High-Resolution Spherical Quantization of Sinusoidal Parameters", IEEE TRANSACTIONS ON AUDIO, SPEECH AND LANGUAGE PROCESSING, IEEE SERVICE CENTER, NEW YORK, NY, USA, vol. 15, no. 3, 1 March 2007 (2007-03-01), pages 966-981, XP011165556, ISSN: 1558-7916, DOI: 10.1109/TASL.2006.885929
- SUNG K.-M. ET AL.: 'A Multi-Channel Audio Compression Method with Virtual Source Location Information for MPEG-4 SAC' IEEE TRANSACTIONS ON CONSUMER ELECTRONICS vol. 51, no. 4, November 2005, XP003008934

## Description

### Technical Field

Methods and apparatuses consistent with the present invention relate to audio coding and decoding, and more particularly, to coding and decoding an amplitude of partials in a parametric codec.

### Background Art

Document D1: "ASAC - Analysis/Synthesis Audio Codec for Very Low Bit Rates" Edler et al, AES Convention May 1996, XP001062332 is an example of the known art. The claims have been characterised against this document.

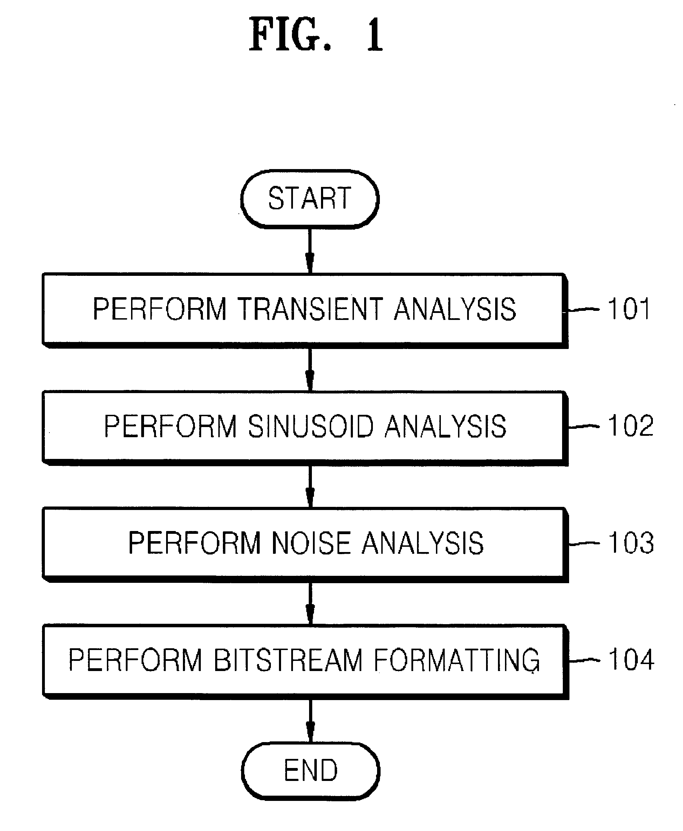

A parametric codec is a combination of parametric coding for parsing and parametrizing an audio signal and parametric decoding for reconstructing a parameter to an audio signal. FIG. 1 is a flowchart of a related art parametric coding method. Parameters for audio components in each domain are extracted by performing three types of analysis, i.e., performing transient analysis in operation 101, performing sinusoidal analysis in operation 102, and performing noise analysis in operation 103.

The transient analysis deals with a dynamic audio change. The sinusoidal analysis deals with a deterministic audio change. The noise analysis deals with a stochastic or non-deterministic audio change. The extracted parameters are formatted into a bitstream in operation 104.

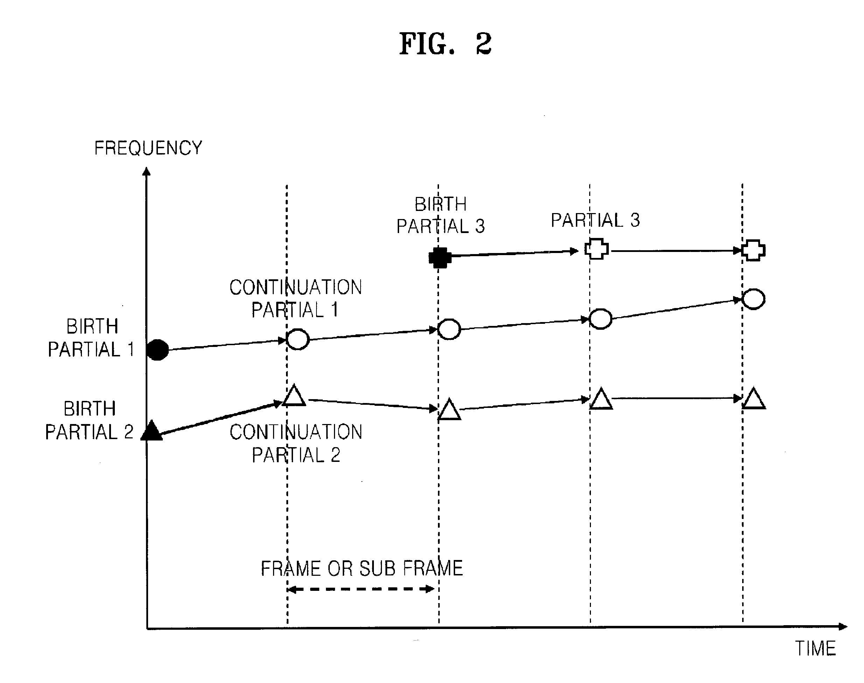

In related art parametric coding, the sinusoidal analysis involves analyzing a sinusoid of an input audio signal in order to generate partials and tracking generated partials. The partials are divided into continuation partials and birth partials by the tracking. As illustrated in FIG. 2, the continuation partials are related to partials of a previous frame and the birth partials are newly generated irrespective of the partials of the previous frame.

Related art parametric coding has more continuation partials than birth partials. Thus, a reduction in the number of bits for expressing the continuation partials and an improvement in the sound quality of the continuation partials exert a large influence on the reduction in the total number of bits and improvement in overall audio quality.

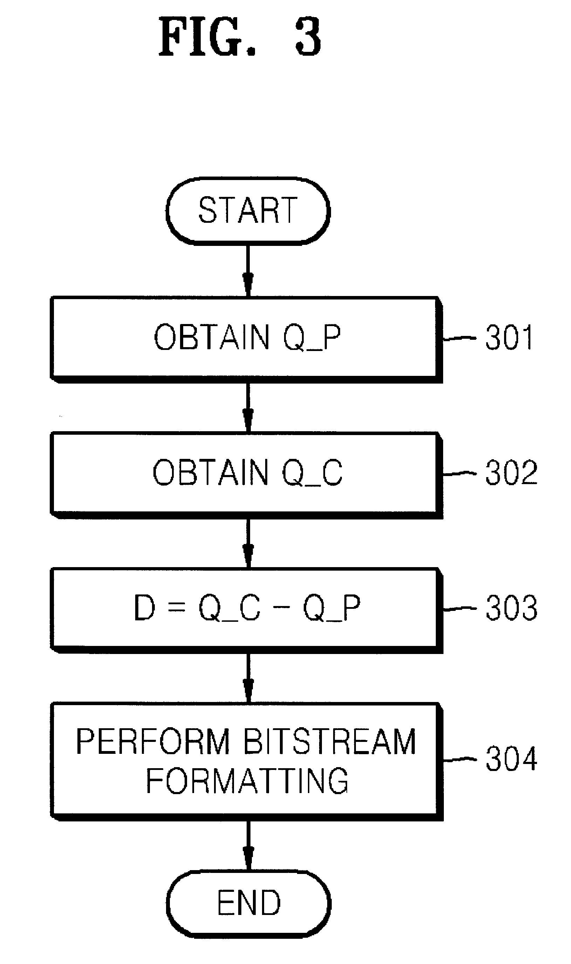

Referring to FIG. 3, in related art parametric coding, amplitude coding of continuation partials is performed by obtaining a quantized value Q_P of the amplitude of partials of a previous frame using a log scale method in operation 301 and a quantized value Q_C of the amplitude of partials of the current frame using a log scale method in operation 302. Next, a difference between the quantized value Q_P and the quantized value Q_C, i.e., D=Q_C - Q_P, is obtained in operation 303 and the obtained difference D is formatted into a bitstream in operation 304, thereby reducing the number of bits of continuation partials after being coded.

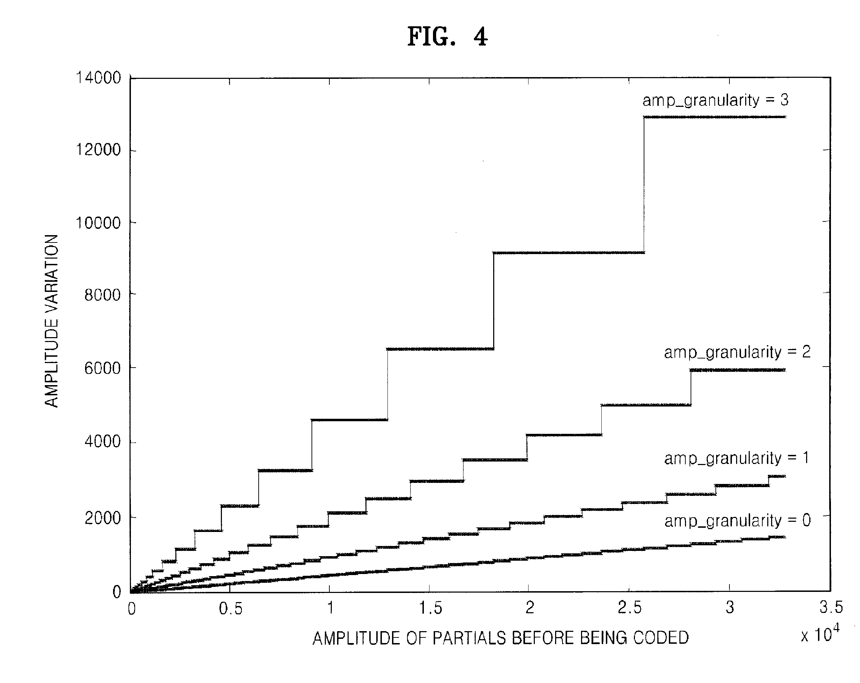

However, during amplitude coding of continuation partials, if the amplitude of the continuation partials gradually increases or decreases, a gradual amplitude variation cannot be expressed and only a large amplitude variation can be expressed, resulting in a step phenomenon in an amplitude variation as illustrated in FIG. 4.

FIG. 4 is a graph showing a relationship between the amplitude of continuation partials before being coded with respect to preset amplitude granularities (amp_granularity) and an amplitude variation with respect to a change of 1 in the quantized value Q_C. In FIG. 4, a horizontal axis indicates the amplitude of continuation partials before being coded and a vertical axis indicates an amplitude variation when the quantized value Q_C changes by 1.

### Disclosure of Invention

### Technical Problem

Referring to FIG. 4, for an amp_granularity of 0, a step phenonmenon does not occur in an amplitude variation. However, as the amp_granularity increases, the step phenonmenon occurs to a large extent in the amplitude variation, causing degradation in reproduced sound quality.

Moreover, in related art amplitude coding of continuation partials, a difference between a quantized value of the amplitude of partials of a previous frame, which is obtained using a log scale method, and a quantized value of the amplitude of partials of the current frame, which is also obtained using the log scale method, i.e., the difference D in FIG. 3, is formatted into a bitstream without considering a frequency domain, causing a failure in efficiently reducing the number of bits of continuation partials. Furthermore, a large number of bits are used for expressing an amplitude variation in a small-amplitude portion that is not perceivable by human ears, resulting in a failure to efficiently reduce the number of bits in coding an audio signal.

### Technical Solution

The present invention provides a method and apparatus for coding and decoding an amplitude of partials, in which the occurrence of a step phenonmenon in an amplitude variation is prevented during coding of the amplitude of continuation partials in a parametric codec, thereby improving reproduced sound quality.

The present invention also provides a method and apparatus for coding and decoding an amplitude of partials, in which the number of bits for expressing the amplitude of continuation partial in a parametric codec can be reduced. The invention is set forth by independent claims 1,4,10,12.

### Advantageous Effects

As described above, according to the exemplary embodiments of the present invention, the amplitude of partials of the current frame is quantized using a quantization level determined based on a function for an inversely quantized amplitude of partials of a previous frame, thereby preventing a step phenomenon in an amplitude variation when coding with respect to the amplitude of continuation partial partials and improving reproduced sound quality.

Moreover, by determining a quantization level adaptively according to frequency, the number of bits for expressing the coded amplitude of continuation partial partials can be reduced. In particular, the number of bits for expressing the variation of a small-amplitude portion that is not perceivable by human ears in an amplitude of partials is reduced, thereby reducing the total number of bits in a parametric codec.

### Description of Drawings

The above and other aspects of the present invention will become more apparent by describing in detail an exemplary embodiment thereof with reference to the attached drawings in which:

FIG. 1 is a flowchart of a related art parametric coding method;

FIG. 2 is a view for explaining birth partial and continuation partial in related art parametric coding;

FIG. 3 is a flowchart of a method of coding the amplitude of continuation partials in related art parametric coding;

FIG. 4 is a graph showing a relationship between the amplitude of continuation partials before being coded with respect to preset amplitude granularities and an amplitude variation with respect to a change of 1 in a quantized value of the amplitude of partials of the current frame;

FIG. 5 is a block diagram of an apparatus for coding the amplitude of partials according to an exemplary embodiment of the present invention;

FIG. 6 is a graph showing a relationship between the amplitude of partials with respect to a preset function according to an exemplary embodiment of the present invention and an amplitude variation with respect to a change of 1 in a quantized value of the amplitude of partials of the current frame;

FIG. 7 is a graph for comparing the graph illustrated in FIG. 4 with the graph illustrated in FIG. 6;

FIG. 8 is a flowchart of a method of coding the amplitude of partials according to an exemplary embodiment of the present invention;

FIG. 9 is a block diagram of an apparatus for decoding the amplitude of partials according to an exemplary embodiment of the present invention; and

FIG. 10 is a flowchart of a method of decoding the amplitude of partials according to an exemplary embodiment of the present invention.

### Best Mode

According to one aspect of the present invention, there is provided a method of coding an amplitude of partials, the method including obtaining an inversely quantized amplitude of partials of a previous frame; determining a quantization level based on a function for the inversely quantized amplitude of the partials of the previous frame; and quantizing an amplitude of partials of a current frame according to the determined quantization level.

According to one aspect of the present invention, there is provided an apparatus for coding an amplitude of partials, the apparatus including a storage unit storing an inversely quantized amplitude of partials of a previous frame; a quantization level determination unit determining a quantization level based on a function for the inversely quantized amplitude of the partials of the previous frame; and a quantization unit quantizing an amplitude of partials of a current frame according to the determined quantization level.

According to one aspect of the present invention, there is provided a method of decoding an amplitude of partials, the method including detecting a quantized value of partials of a current frame from a bitstream-deformatted signal; obtaining an inversely quantized amplitude of partials of a previous frame; determining a quantization level based on a function for the inversely quantized amplitude of the partials of the previous frame; and inversely quantizing the detected quantization value according to the determined quantization level.

According to another aspect of the present invention, there is provided an apparatus for decoding an amplitude of partials, the apparatus including a quantized value detection unit detecting a quantized value of partials of a current frame from a bitstream-deformatted signal; a storage unit storing an inversely quantized amplitude of partials of a previous frame; a quantization level detection unit detecting a quantization level based on a function for the inversely quantized amplitude of the partials of the previous frame; and an inverse quantization unit inversely quantizing the detected quantization value according to the determined quantization level.

### Mode for Invention

Hereinafter, exemplary embodiments of the present invention will be described in detail with reference to the accompanying drawings. It should be noted that like reference numerals refer to like elements illustrated in one or more of the drawings. In the following description of the present invention, detailed description of known functions and configurations incorporated herein will be omitted for conciseness and clarity.

The exemplary embodiments of the present invention determine a quantization level based on a function for an amplitude of partials of a previous frame and quantizes the amplitude of partials of the current frame based on the determined quantization level in order to prevent a step phenomenon from occurring in the result of coding with respect to the amplitude of continuation partial partials in a parametric codec. Moreover, the exemplary embodiments of the present invention adjust the function in order to change the quantization level according to frequency, thereby reducing the number of bits used for expressing the amplitude variation of the continuation partials. The exemplary embodiments of the present invention can also reduce the number of bits used for expressing the amplitude variation of a small-amplitude portion that is not perceivable by human ears.

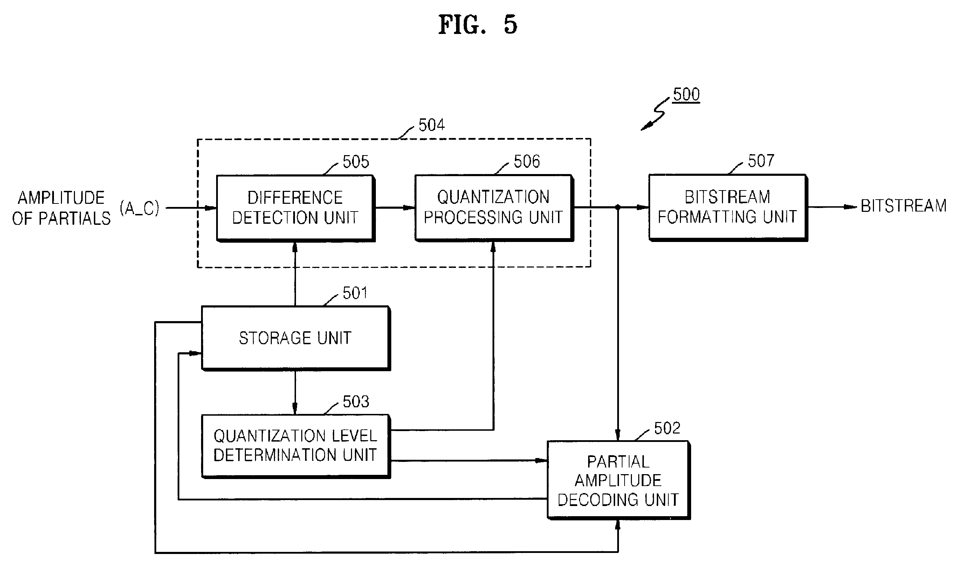

FIG. 5 is a block diagram of an apparatus 500 for coding the amplitude of partials according to the present invention. Referring to FIG. 5, the apparatus 500 includes a storage unit 501, a partial amplitude decoding unit 502, a quantization level determination unit 503, a quantization unit 504, and a bitstream formatting unit 507.

The storage unit 501 stores an inversely quantized amplitude (or a decoded amplitude) of the amplitude of partials of the current frame, which is provided from the partial amplitude decoding unit 502, and provides the stored inversely quantized amplitude as an inversely quantized amplitude prev_iq_amp (or a decoded amplitude) of the amplitude of partials of a previous frame, which hereinafter will be referred to as an inversely quantized amplitude for the partials of the previous frame, during quantization with respect to the amplitude of partials of a next frame.

Upon receipt of a quantized value D of partials of the current frame from the quantization unit 504, the partial amplitude decoding unit 502 inversely quantizes the received quantized value D in order to obtain an inversely quantized value. In other words, the partial amplitude decoding unit 502 obtains the inversely quantized value by multiplying the received quantized value D by a quantization level provided from the quantization level determination unit 503. The partial amplitude decoding unit 502 then reads the inversely quantized amplitude for the partial of the previous frame, which is stored in the storage unit 501, and stores the result of adding the read inversely quantized amplitude to the inversely quantized value in the storage unit 501 as a decoded amplitude for the amplitude of partials of the current frame.

The quantization level determination unit 503 determines a quantization level Q_Level based on a preset function f(prev_iq_amp) for the inversely quantized amplitude of partials of the previous frame, i.e., Q_Level=f(prev_iq_amp). The function f(prev_iq_amp) may be set as a fixed function irrespective of the frequency of the partials. For example, if the amplitude of the partials of the previous frame is x, the function may be set to Q-Level=(x)^{(1/2)} irrespective of frequency in order to determine the quantization level.

Human ears easily recognize a change in the amplitude of partials in a low-frequency domain, but this is not the case in a high-frequency domain. Thus, the quantization level may be determined by setting the function differently for the low-frequency domain and the high-frequency domain. For example, if the amplitude of the partials of the previous frame is x, the function is set to Q-Level=(x)^{(1/2)} in the low-frequency domain and to Q_Level=(x)^{(3/5)} in the high-frequency domain in order to determine the quantization level.

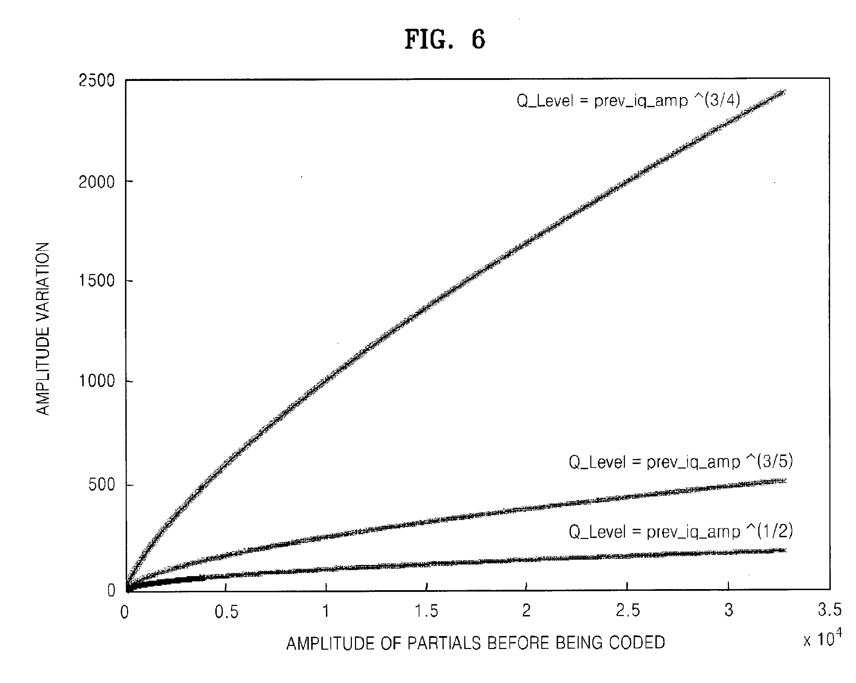

Alternatively, the function may be set differently for a low-frequency domain, an intermediate-frequency domain and a high-frequency domain. For example, as illustrated in FIG. 6, the quantization level is determined by setting the function to Q_Level=(x) (1/2) in the low-frequency domain, by setting the function to Q_Level=(x)^{(3/5)} in the intermediate-frequency domain, and by setting the function to Q_Level=(x)^{(3/4)} in the high-frequency domain. FIG. 6 is a graph showing a relationship between the amplitude of partials before being coded with respect to a function used for determining a quantization level according to the frequency of the partials and an amplitude variation with respect to a change of 1 in a quantized value of the amplitude of partials of the current frame. As can be seen from FIG. 6, a step phenomenon does not occur in an amplitude variation. This is because the amplitude of partials of the current frame is quantized using a quantization level that is set adaptively to an inversely quantized amplitude of partials of a previous frame. The quantization level determination unit 503 may determine the quantization level by setting the function in such a way that a quantization error in a high-frequency domain becomes larger than a quantization error in a low-frequency domain.

The quantization unit 504 quantizes the amplitude of partials of the current frame based on the quantization level determined by the quantization level determination unit 503. To this end, the quantization unit 504 includes a difference detection unit 505 and a quantization processing unit 506.

The difference detection unit 505 detects a difference Diff=A_C - prev_iq_amp between the amplitude A_C of partial of the current frame and an inversely quantized amplitude prev_iq_amp of partials of the previous frame. To this end, upon receipt of the amplitude A_C, the difference detection unit 505 reads the inversely quantized amplitude prev_iq_amp stored in the storage unit 501 and detects the difference between the amplitude A_C and the read inversely quantized amplitude prev_iq_amp.

The quantization processing unit 506 quantizes the difference detected by the difference detection unit 505 based on the quantization level determined by the quantization level determination unit 503, thereby obtaining a quantized value D of the amplitude of partials of the current frame. In other words, the quantization processing unit 506 may quantize the amplitude A_C based on an operation Diff/Q_Level of dividing the difference by the determined quantization level. At this time, the quantized value D obtained by the quantization processing unit 506 may be defined as the coded amplitude of the partials of the current frame. The quantization processing unit 506 may apply the obtained quantized value D to one of a rounding function round(Diff/Q_Level), a ceiling function and a floor function. A signal output from the quantization processing unit 506 is transmitted to the bitstream formatting unit 507 and then to the partial amplitude decoding unit 502.

The bitstream formatting unit 507 performs bitstream formatting on the quantized value transmitted form the quantization unit 504 and transmits the resulting value to an apparatus for decoding the amplitude of partials of the current frame or an apparatus for decoding an audio signal.

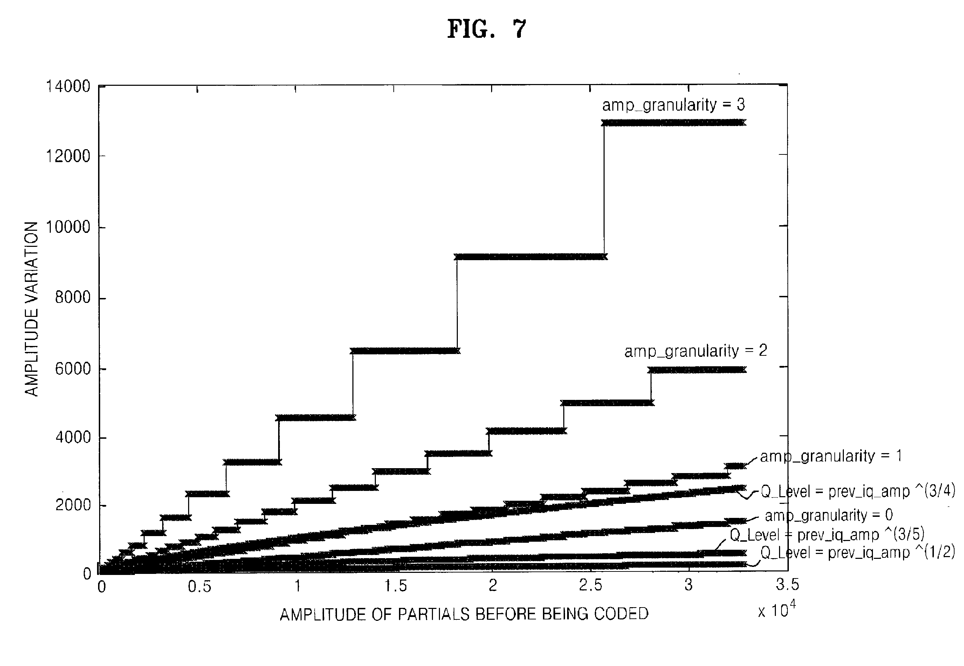

FIG. 7 is a graph for comparing the graph illustrated in FIG. 4 with the graph illustrated in FIG. 6. Referring to FIG. 7, a step phenomenon occurs in an amplitude variation with respect to a change of 1 in a quantized value of the amplitude of partials as the amplitude of the partials gradually increases in conventional partial amplitude coding as can be seen in the graph based on FIG. 4, whereas a step phenomenon does not occur in an amplitude variation with respect to a change of 1 in a quantized value of the amplitude of partials as the amplitude of the partials gradually increases in partial amplitude coding according to the present invention as can be seen in the graph based on FIG. 6.

Referring to FIG. 4, in the graph based on FIG. 4, related art partial amplitude coding cannot follow a gradual increase in the amplitude variation of partials. Although related art partial amplitude coding can express a gradual increase in the amplitude variation of partials for an amplitude granularity amp_granularity of 0, a large amount of bits are required for expressing the gradual increase.

On the other hand, in the graph based on FIG. 6, partial amplitude coding according to the present invention can express a gradual increase in the amplitude variation of partials. A function for determining the quantization level can be set differently. For example, the function may be set to (prev_iq_amp)^{(1/2)}, (prev_iq_amp)^{(3/5)}, and (prev_iq_amp)^{(3/4)}. By setting different quantization levels for different frequencies using a psychoacoustic method, the amount of bits can be reduced and sound quality degradation can also be prevented. For example, the function f(prev_iq_amp) for determining the quantization level is set to (prev_iq_amp)^{(1/2)} in a low-frequency domain, to (prev_iq_amp)^{(3/5)} in an intermediate-frequency domain, and to (prev_iq_amp)^{(3/4)} in a high-frequency domain.

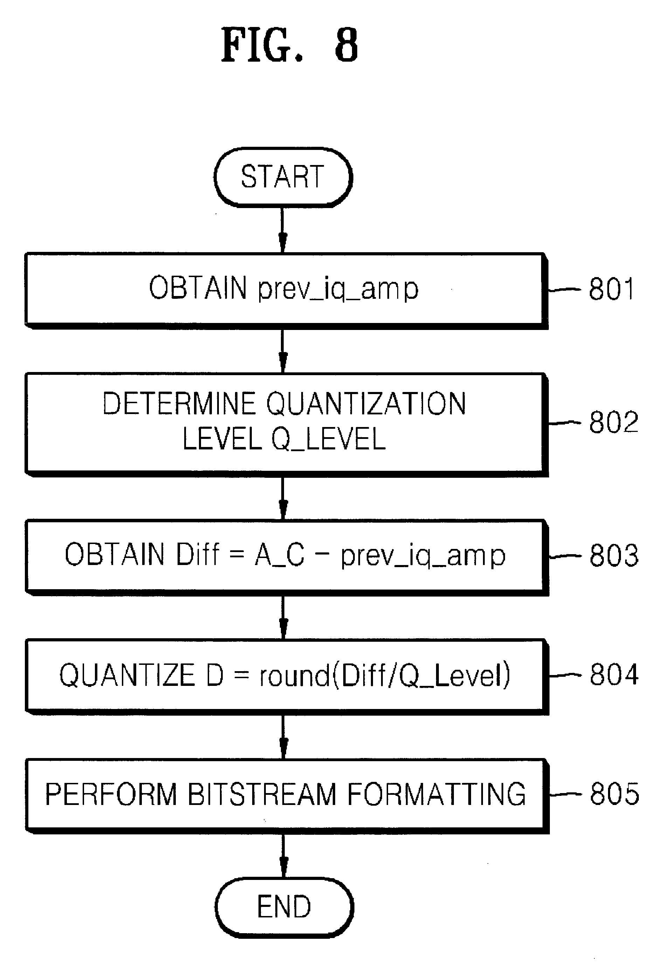

FIG. 8 is a flowchart of a method of coding the amplitude of partials according to an exemplary embodiment of the present invention.

Referring to FIG. 8, an inversely quantized amplitude prev_iq_amp of partials of a previous frame is obtained in operation 801 in a similar manner to a manner in which the partial amplitude decoding unit 502 of FIG. 5 obtains an inversely quantized amplitude of partials of the current frame.

In operation 802, a quantization level Q_Level for quantizing the amplitude of partials of the current frame is determined using the inversely quantized amplitude prev_iq_amp. In other words, as already described regarding the quantization level determination unit 503 of FIG. 5, a preset function is applied to the inversely quantized amplitude prev_iq_amp obtained in operation 801, thereby determining the quantization level Q_Level. The function may be set as described with reference to FIG. 5.

In operation 803, a difference Diff = A_C - prev_iq_amp between the amplitude A_C of partials of the current frame and the inversely quantized amplitude prev_id_amp of the partials of the previous frame, which is obtained in operation 801, is obtained.

In operation 804, the difference Diff is quantized based on the quantization level Q_Level determined in operation 802. In other words, the difference Diff is quantized by applying a rounding function round(Diff/Q_Level) to the result of dividing the difference Diff by the quantization level Q_Level. However, the difference Diff may also be quantized by applying a ceiling function or a floor function to the result of the division. The quantized difference is a quantized value of the amplitude of the partials of the current frame. Thus, operation 803 and 804 may be defined as an operation of quantizing the amplitude of partials of the current frame based on the quantization level. In operation 805, the quantized value obtained in operation 801 is formatted into a bitstream.

Alternatively, operation 801 may be changed so that an inversely quantized amplitude of partials of the previous frame, which is stored in operation 801, is read in operation 801 and operation 805 may be changed so that bitstream formatting is performed and an inversely quantized amplitude of partials of the current frame is obtained and stored as described regarding the partial amplitude decoding 502 of FIG. 5. Thus, when the amplitude of partials of a next frame is coded, the stored inversely quantized amplitude of partials of the current frame may be read as an inversely quantized amplitude of partials of a previous frame.

In FIG. 8, the order of processing operation 802 and operation 803 are interchangeable.

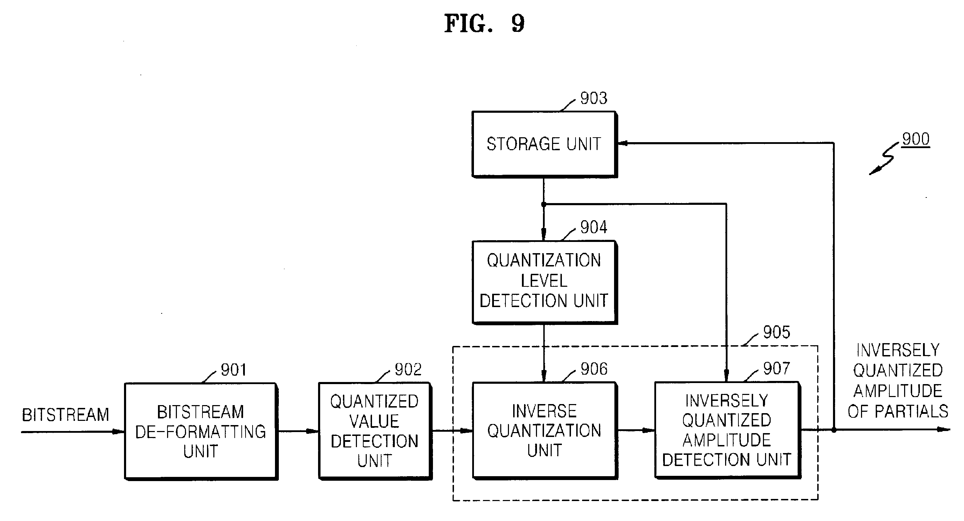

FIG. 9 is a block diagram of an apparatus 900 for decoding the amplitude of partials according to an exemplary embodiment of the present invention. Referring to FIG. 9, the apparatus 900 includes a bitstream de-formatting unit 901, a quantized value detection unit 902, a storage unit 903, a quantization level detection unit 904, and an inverse quantization unit 905.

The bitstream de-formatting unit 901 de-formats a received bitstream.

Upon receipt of a bitstream de-formatted signal from the bitstream de-formatting unit 901, the quantized value detection unit 902 detects a quantized value of the amplitude of the partials of the current frame from the bitstream de-formatted signal. Such detection may be performed by, for example, detecting a quantized value from a preset field in the received bitstream de-formatted signal.

The storage unit 903 stores an inversely quantized amplitude of the partials of the current frame, which is output from the inverse quantization unit 905, and provides the stored inversely quantized amplitude as an inversely quantized amplitude of partials of the previous frame when inversely quantizing with respect to a quantized value of the amplitude of partials of a next frame.

The quantization level detection unit 904 detects a quantization level based on a function for the inversely quantized amplitude of partials of the previous frame, which is provided from the storage unit 903. The function is similar to that described regarding the apparatus 500 illustrated in FIG. 5 for coding the amplitude of partials according to the present invention.

The inverse quantization unit 905 inversely quantizes the quantized value detected by the quantized value detection unit 902 according to the quantization level detected by the quantization level detection unit 904. To this end, the inverse quantization unit 905 includes an inverse quantization block 906 and an inversely quantized amplitude detection unit 907.

The inverse quantization block 906 inversely quantizes the quantized value of the amplitude of the partials of the current frame based on the quantization level detected by the quantization level detection unit 904, thereby outputting an inversely quantized value of the amplitude of the partials of the current frame. The inversely quantized amplitude detection unit 907 detects an inversely quantized amplitude of the partials of the current frame based on the inversely quantized value output from the inverse quantization block 906 and the inversely quantized amplitude of the partials of the previous frame, which is read from the storage unit 903. In other words, the inversely quantized amplitude detection unit 907 outputs the result of adding the inversely quantized amplitude of the partials of the previous frame to the output inversely quantized value as the inversely quantized amplitude of the partials of the current frame. The output inversely quantized amplitude of the partials of the current frame is transmitted to the storage unit 903 and is also transmitted to a signal processing unit (not shown) for audio reproduction.

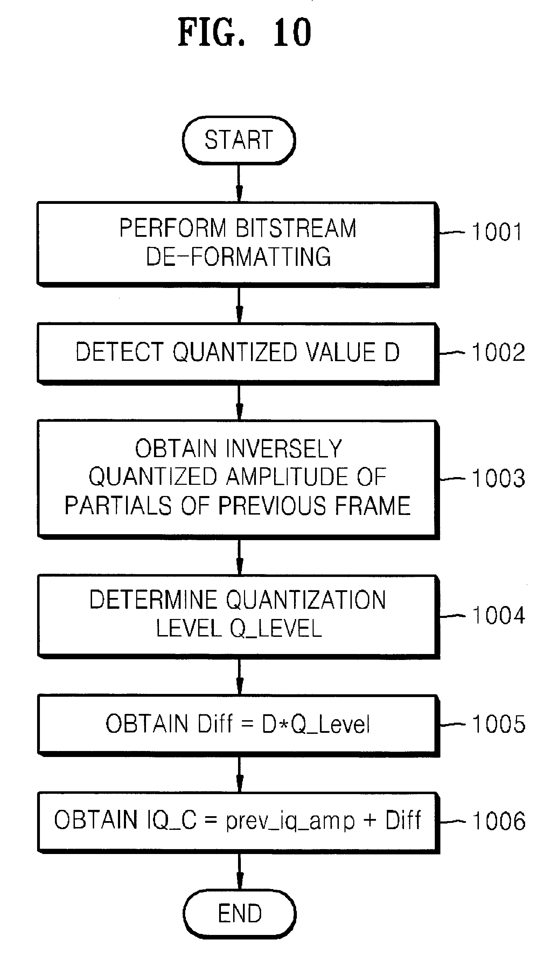

FIG. 10 is a flowchart of a method of decoding the amplitude of partials according to an exemplary embodiment of the present invention.

Referring to FIG. 10, a received bitstream is de-formatted in operation 1001. In operation 1002, a quantized value D of the amplitude of partials of the current frame is detected from a bitstream de-formatted signal. The detection is similar to that described with reference to FIG. 9.

In operation 1003, an inversely quantized amplitude prev_iq_amp of partials of a previous frame is obtained. The inversely quantized amplitude prev_iq_amp is obtained by adding an inversely quantized amplitude of a frame preceding the previous frame to an inversely quantized value of the amplitude of the partials of the previous frame.

In operation 1004, a quantization level Q_Level is determined based on a function for the inversely quantized amplitude prev_iq_amp. In other words, the quantization level Q_Level is determined by applying the preset function to the inversely quantized amplitude prev_iq_amp.

In operation 1005, an inversely quantized value Diff of the amplitude of partials of the current frame is obtained based on the quantized value D and the quantization level Q_Level determined in operation 1004. In other words, the inversely quantized value Diff is obtained by multiplying the quantized value D by the quantization level Q_Level.

In operation 1006, an inversely quantized amplitude IQ_C or cur_iq_amp of the partials of the current frame is obtained based on the inversely quantized value Diff and the inversely quantized amplitude prev_iq_amp. In other words, the result of adding the inversely quantized amplitude prev_iq_amp to the inversely quantized value Diff is obtained as the inversely quantized amplitude IQ_C.

The obtained inversely quantized amplitude IQ_C is processed in such a way as to reproduce an audio signal and can be stored in order to be used as an inversely quantized amplitude of partials of a previous frame when a quantized value of partials of a next frame is inversely quantized. If the method in FIG. 10 includes an operation storing the inversely quantized amplitude IQ_C obtained in operation 1006, operation 1003 can be defined as operation reading the stored inversely quantized amplitude of partials of the previous frame.

Thus, operations 1005 and 1006 of FIG. 10 may be defined as an operation of inversely quantizing the detected quantized value according to the quantization level.

The method of coding and decoding the amplitude of partials according to the present invention can be embodied as code that is readable by a computer on a computer-readable recording medium. The computer-readable recording medium includes all kinds of recording devices storing data that is readable by a computer system. Examples of the computer-readable recording medium include read-only memory (ROM), random access memory (RAM), CD-ROMs, magnetic tapes, floppy disks, and optical data storage devices. The computer readable recording medium can also be distributed over network coupled computer systems so that the computer readable code is stored and executed in a distributed fashion. Also, functional programs, code, and code segments for implementing the present invention can be easily construed by programmers of ordinary skill in the art.

While the present invention has been particularly shown and described with reference to exemplary embodiments thereof, it will be understood by those of ordinary skill in the art that various changes in form and detail may be made therein without departing from the scope of the present invention as defined by the following claims.

## Claims

1. A method of audio coding an amplitude of partials, the method comprising:
obtaining an inversely quantized amplitude of partials of a previous frame;
determining a quantization level based on the inversely quantized amplitude of the partials of the previous frame; and
quantizing an amplitude of partials of a current frame based on the determined quantization level;
**characterised by** obtaining the inversely quantized amplitude of partials of the previous frame by the steps of:
quantizing the partials of the previous frame;
inversely quantizing the obtained quantized value; and
adding an inversely quantized amplitude of partials of a frame preceding the previous frame to an inversely quantized value obtained by the inverse quantization, thereby obtaining the inversely quantized amplitude of the partials of the previous frame.

2. The method of claim 1, wherein the quantizing the amplitude of the partials of the current frame comprises:
obtaining a difference between the amplitude of the partials of the current frame and the inversely quantized amplitude of the partials of the previous frame; and
quantizing the difference based on the determined quantization level,
wherein a quantized value obtained by quantizing the difference is a quantized value of the amplitude of the partials of the current frame.

3. The method of claim 1, wherein the determining the quantization level determines the quantization level so that the quantization level changes with a frequency.

4. An apparatus (500) for audio coding an amplitude of partials, the apparatus (500) comprising:
a storage unit (501) arranged to store an inversely quantized amplitude of partials of a previous frame;
a quantization level determination unit (503) arranged to determine a quantization level based on the inversely quantized amplitude of the partials of the previous frame; and
a quantization unit (504) arranged to quantize an amplitude of partials of a current frame based on the quantization level determined by the quantization level determination unit (503);
**characterised in that** the quantization unit (504) is further arranged to:
quantize the partials of the previous frame;
inversely quantize the obtained quantized value; and
add an inversely quantized amplitude of partials of a frame preceding the previous frame to an inversely quantized value obtained by the inverse quantization, thereby obtaining the inversely quantized amplitude of the partials of the previous frame.

5. The apparatus of claim 4, wherein the quantization unit (504) comprises:
a difference detection unit (505) arranged to detect a difference between the amplitude of the partials of the current frame and the inversely quantized amplitude of the partials of the previous frame; and
a quantization block (506) arranged to quantize the difference based on the determined quantization level,
wherein a quantized value obtained by the quantization block (506) is a quantized value of the amplitude of the partials of the current frame.

6. The apparatus of claim 4 or 5, further comprising a partial amplitude decoding unit (502) arranged to decode the quantized value of the partials of the current frame, which is output from the quantization unit (504), based on the quantization level.

7. The apparatus of claim 6, wherein the partial amplitude decoding unit (502) is arranged to inversely quantize the quantized value and stores in the storage unit (501) a result of adding the inversely quantized amplitude of the partials of the previous frame, which is read from the storage unit (501), to the inversely quantized value obtained by the inverse quantization.

8. The apparatus of claim 6, wherein the quantization level determination unit (503) is arranged to determine the quantization level so that the quantization level changes with a frequency.

9. The apparatus of claim 6, wherein the quantization unit (504) is arranged to quantize the difference based on an operation of dividing the difference between the amplitude of the partials of the current frame and the inversely quantized amplitude of the partials of the previous frame by the quantization level by the quantization level.

10. A method of audio decoding an amplitude of partials, the method comprising:
detecting a quantized value of partials of a current frame from a bitstream-deformatted signal;
obtaining an inversely quantized amplitude of partials of a previous frame;
determining a quantization level based on the inversely quantized amplitude of the partials of the previous frame; and
inversely quantizing the detected quantization value based on the determined quantization level;
**characterised by** obtaining the inversely quantized amplitude of the partials of the previous frame by the steps of:
inversely quantizing a quantized value of the partials of the previous frame; and
adding an inversely quantized amplitude of partials of a frame preceding the previous frame to the inversely quantized value obtained by the inverse quantization, thereby obtaining the inversely quantized amplitude of the partials of the previous frame.

11. The method of claim 10, wherein the inversely quantizing the detected quantization value comprises:
obtaining an inversely quantized value of the partials of the current frame based on the quantized value and the quantization level; and
obtaining an inversely quantized amplitude of the partials of the current frame based on the inversely quantized value and the inversely quantized amplitude of the partials of the previous frame.

12. An apparatus (900) for audio decoding an amplitude of partials, the apparatus comprising:
a quantized value detection unit (902) arranged to detect a quantized value of partials of a current frame from a bitstream-deformatted signal;
a storage unit (903) arranged to store an inversely quantized amplitude of partials of a previous frame;
a quantization level detection unit (904) arranged to detect a quantization level based on the inversely quantized amplitude of the partials of the previous frame; and
an inverse quantization unit (905) arranged to inversely quantize the quantization value detected by the quantization value detection unit based on the quantization level detected by the quantization level detection unit (904);
**characterised in that** the inverse quantization unit (905) is arranged to:
inversely quantize a quantized value of the partials of the previous frame; and
add an inversely quantized amplitude of partials of a frame preceding the previous frame to the inversely quantized value obtained by the inverse quantization, thereby obtaining the inversely quantized amplitude of the partials of the previous frame.

13. The apparatus of claim 12, wherein the inverse quantization unit (905) comprises:
an inverse quantization block (906) arranged to inversely quantize the quantized value detected by the quantization value detection unit (907) based on the quantization level; and
an inversely quantized amplitude detection unit arranged to detect an inversely quantized amplitude of the partials of the current frame based on the inversely quantized value and the inversely quantized amplitude of the partials of the previous frame,
wherein the inversely quantized amplitude of the partials of the current frame, which is detected by the inversely quantized amplitude detection unit (907), is stored in the storage unit (903).

## Patentansprüche

1. Verfahren zum Audiocodieren einer Amplitude von Partialtönen, wobei das Verfahren Folgendes umfasst:
Erhalten einer invers quantisierten Amplitude von Partialtönen eines vorherigen Rahmens;
Bestimmen eines Quantisierungspegels anhand der invers quantisierten Amplitude der Partialtöne des vorherigen Rahmens; und
Quantisieren einer Amplitude der Partialtöne eines aktuellen Rahmens anhand des bestimmten Quantisierungspegels;
**gekennzeichnet durch** Erhalten der invers quantisierten Amplitude der Partialtöne des vorherigen Rahmens **durch** die folgenden Schritte:
Quantisieren der Partialtöne des vorherigen Rahmens;
inverses Quantisieren des erhaltenen quantisierten Werts; und
Addieren einer invers quantisierten Amplitude der Partialtöne eines Rahmens, der dem vorherigen Rahmen vorausgeht, zu einem invers quantisierten Wert, der durch die inverse Quantisierung erhalten wurde, wodurch die invers quantisierte Amplitude der Partialtöne des vorherigen Rahmens erhalten wird.

2. Verfahren nach Anspruch 1, wobei das Quantisieren der Amplitude der Partialtöne des aktuellen Rahmens Folgendes umfasst:
Erhalten eines Unterschieds zwischen der Amplitude der Partialtöne des aktuellen Rahmens und der invers quantisierten Amplitude der Partialtöne des vorherigen Rahmens; und
Quantisieren des Unterschieds anhand des bestimmten Quantisierungspegels,
wobei ein quantisierter Wert, der durch Quantisieren des Unterschieds erhalten wird, ein quantisierter Wert der Amplitude der Partialtöne des aktuellen Rahmens ist.

3. Verfahren nach Anspruch 1, wobei das Bestimmen des Quantisierungspegels den Quantisierungspegel derart bestimmt, dass sich der Quantisierungspegel mit einer Frequenz ändert.

4. Vorrichtung (500) zum Audiocodieren einer Amplitude von Partialtönen, wobei die Vorrichtung (500) Folgendes umfasst:
eine Speichereinheit (501), die ausgelegt ist, eine invers quantisierte Amplitude der Partialtöne eines vorherigen Rahmens zu speichern;
eine Quantisierungspegelbestimmungseinheit (503), die ausgelegt ist, einen Quantisierungspegel anhand der invers quantisierten Amplitude der Partialtöne des vorherigen Rahmens zu bestimmen; und
eine Quantisierungseinheit (504), die ausgelegt ist, eine Amplitude der Partialtöne eines aktuellen Rahmens anhand des Quantisierungspegels, der durch die Quantisierungspegelbestimmungseinheit (503) bestimmt wurde, zu quantisieren;
**dadurch gekennzeichnet, dass** die Quantisierungseinheit (504) ferner ausgelegt ist,
die Partialtöne des vorherigen Rahmens zu quantisieren;
den erhaltenen quantisierten Wert invers zu quantisieren; und
eine invers quantisierte Amplitude der Partialtöne eines Rahmens, der dem vorherigen Rahmen vorausgeht, zu einem invers quantisierten Wert, der durch die inverse Quantisierung erhalten wurde, zu addieren, wodurch die invers quantisierte Amplitude der Partialtöne des vorherigen Rahmens erhalten wird.

5. Vorrichtung nach Anspruch 4, wobei die Quantisierungseinheit (504) Folgendes umfasst:
eine Unterschiedsdetektionseinheit (505), die ausgelegt ist, einen Unterschied zwischen der Amplitude der Partialtöne des aktuellen Rahmens und der invers quantisierten Amplitude der Partialtöne des vorherigen Rahmens zu detektieren; und
einen Quantisierungsblock (506), der ausgelegt ist, den Unterschied anhand des bestimmten Quantisierungspegels zu quantisieren,
wobei ein quantisierter Wert, der durch den Quantisierungsblock (506) erhalten wird, ein quantisierter Wert der Amplitude der Partialtöne des aktuellen Rahmens ist.

6. Vorrichtung nach Anspruch 4 oder 5, die ferner eine Partialtonamplitudendecodierungseinheit (502) umfasst, die ausgelegt ist, den quantisierten Wert der Partialtöne des aktuellen Rahmens, der von der Quantisierungseinheit (504) ausgegeben wird, anhand des Quantisierungspegels zu decodieren.

7. Vorrichtung nach Anspruch 6, wobei die Partialtonamplitudendecodierungseinheit (502) ausgelegt ist, den quantisierten Wert invers zu quantisieren, und ein Ergebnis des Addierens der invers quantisierten Amplitude der Partialtöne des vorherigen Rahmens, die aus der Speichereinheit (501) ausgelesen wird, zu dem invers quantisierten Wert, der durch die inverse Quantisierung erhalten wurde, in der Speichereinheit (501) zu speichern.

8. Vorrichtung nach Anspruch 6, wobei die Quantisierungspegelbestimmungseinheit (503) ausgelegt ist, den Quantisierungspegel derart zu bestimmen, dass sich der Quantisierungspegel mit einer Frequenz ändert.

9. Vorrichtung nach Anspruch 6, wobei die Quantisierungseinheit (504) ausgelegt ist, den Unterschied anhand eines Vorgangs des Dividierens des Unterschieds zwischen der Amplitude der Partialtöne des aktuellen Rahmens und der invers quantisierten Amplitude der Partialtöne des vorherigen Rahmens durch den Quantisierungspegel durch den Quantisierungspegel zu quantisieren.

10. Verfahren zum Audiodecodieren einer Amplitude von Partialtönen, wobei das Verfahren Folgendes umfasst:
Detektieren eines quantisierten Werts von Partialtönen eines aktuellen Rahmens aus einem bitstrom-deformatierten Signal;
Erhalten einer invers quantisierten Amplitude von Partialtönen eines vorherigen Rahmens;
Bestimmen eines Quantisierungspegels anhand der invers quantisierten Amplitude der Partialtöne des vorherigen Rahmens; und
inverses Quantisieren des detektierten Quantisierungswerts anhand des bestimmten Quantisierungspegels;
**gekennzeichnet durch** Erhalten der invers quantisierten Amplitude der Partialtöne des vorherigen Rahmens **durch** die folgenden Schritte:
inverses Quantisieren eines quantisierten Werts der Partialtöne des vorherigen Rahmens; und
Addieren einer invers quantisierten Amplitude der Partialtöne eines Rahmens, der dem vorherigen Rahmen vorausgeht, zu dem invers quantisierten Wert, der **durch** die inverse Quantisierung erhalten wurde, wodurch die invers quantisierte Amplitude der Partialtöne des vorherigen Rahmens erhalten wird.

11. Verfahren nach Anspruch 10, wobei das inverse Quantisieren des detektierten Quantisierungswerts Folgendes umfasst:
Erhalten eines invers quantisierten Werts der Partialtöne des aktuellen Rahmens anhand des quantisierten Werts und des Quantisierungspegels; und
Erhalten einer invers quantisierten Amplitude der Partialtöne des aktuellen Rahmens anhand des invers quantisierten Werts und der invers quantisierten Amplitude der Partialtöne des vorherigen Rahmens.

12. Vorrichtung (900) zum Audiodecodieren einer Amplitude von Partialtönen, wobei die Vorrichtung Folgendes umfasst:
eine Detektionseinheit für den quantisierten Wert (902), die ausgelegt ist, einen quantisierten Wert der Partialtöne eines aktuellen Rahmens aus einem bitstrom-deformatierten Signal zu detektieren;
eine Speichereinheit (903), die ausgelegt ist, eine invers quantisierte Amplitude der Partialtöne eines vorherigen Rahmens zu speichern;
eine Quantisierungspegeldetektionseinheit (904), die ausgelegt ist, einen Quantisierungspegel anhand der invers quantisierten Amplitude der Partialtöne des vorherigen Rahmens zu detektieren; und
eine inverse Quantisierungseinheit (905), die ausgelegt ist, den Quantisierungswert, der durch die Quantisierungswertdetektionseinheit detektiert wurde, anhand des durch die Quantisierungspegeldetektionseinheit (904) detektierten Quantisierungspegels invers zu quantisieren;
**dadurch gekennzeichnet, dass** die inverse Quantisierungseinheit (905) ausgelegt ist,
einen quantisierten Wert der Partialtöne des vorherigen Rahmens invers zu quantisieren; und
eine invers quantisierte Amplitude der Partialtöne eines Rahmens, der dem vorherigen Rahmen vorausgeht, zu dem invers quantisierten Wert, der durch die inverse Quantisierung erhalten wurde, zu addieren, wodurch die invers quantisierte Amplitude der Partialtöne des vorherigen Rahmens erhalten wird.

13. Vorrichtung nach Anspruch 12, wobei die inverse Quantisierungseinheit (905) Folgendes umfasst:
einen inversen Quantisierungsblock (906), der ausgelegt ist, den durch die Quantisierungswertdetektionseinheit (907) detektierten quantisierten Wert anhand des Quantisierungspegels invers zu quantisieren; und
eine Detektionseinheit für eine invers quantisierte Amplitude, die ausgelegt ist, eine invers quantisierte Amplitude der Partialtöne des aktuellen Rahmens anhand des invers quantisierten Werts und der invers quantisierten Amplitude der Partialtöne des vorherigen Rahmens zu detektieren,
wobei die invers quantisierte Amplitude der Partialtöne des aktuellen Rahmens, die durch die Detektionseinheit für eine invers quantisierte Amplitude (907) detektiert wird, in der Speichereinheit (903) gespeichert wird.

## Revendications

1. Procédé de codage audio d'une amplitude de partiels, lequel procédé consiste à :
- obtenir une amplitude quantifiée inversement de partiels d'une trame précédente ;
- déterminer un niveau de quantification en fonction de l'amplitude quantifiée inversement des partiels de la trame précédente ; et
- quantifier une amplitude de partiels d'une trame courante en fonction du niveau de quantification déterminé ;
- **caractérisé en ce que** l'on obtient l'amplitude quantifiée inversement de partiels de la trame précédente par les étapes consistant à :
- quantifier les partiels de la trame précédente ;
- quantifier inversement la valeur quantifiée obtenue ; et
- ajouter une amplitude quantifiée inversement de partiels d'une trame précédant la trame précédente à une valeur quantifiée inversement obtenue par la quantification inverse, ceci de manière à obtenir l'amplitude quantifiée inversement des partiels de la trame précédente.

2. Procédé selon la revendication 1, dans lequel la quantification de l'amplitude des partiels de la trame courante consiste à :
- obtenir une différence entre l'amplitude des partiels de la trame courante et l'amplitude quantifiée inversement des partiels de la trame précédente ; et
- quantifier la différence en fonction du niveau de quantification déterminé ;
- dans lequel une valeur quantifiée obtenue en quantifiant la différence est une valeur quantifiée de l'amplitude des partiels de la trame courante.

3. Procédé selon la revendication 1, dans lequel le fait de déterminer le niveau de quantification consiste à déterminer le niveau de quantification de sorte qu'il change avec une fréquence.

4. Appareil (500) de codage audio d'une amplitude de partiels, lequel appareil (500) comprend :
- une unité de stockage (501) conçue pour stocker une amplitude quantifiée inversement de partiels d'une trame précédente ;
- une unité de détermination de niveau de quantification (503) conçue pour déterminer un niveau de quantification en fonction de l'amplitude quantifiée inversement des partiels de la trame précédente ; et
- une unité de quantification (504) conçue pour quantifier une amplitude de partiels d'une trame courante en fonction du niveau de quantification déterminé par l'unité de détermination de niveau de quantification (503) ;
- **caractérisé en ce que** l'unité de quantification (504) est en outre conçue pour :
- quantifier les partiels de la trame précédente ;
- quantifier inversement la valeur quantifiée obtenue ; et
- ajouter une amplitude quantifiée inversement de partiels d'une trame précédant la trame précédente à une valeur quantifiée inversement obtenue par la quantification inverse, ceci de manière à obtenir l'amplitude quantifiée inversement des partiels de la trame précédente.

5. Appareil selon la revendication 4, dans lequel l'unité de quantification (504) comprend :
- une unité de détection de différence (505) conçue pour détecter une différence entre l'amplitude des partiels de la trame courante et l'amplitude quantifiée inversement des partiels de la trame précédente ; et
- un bloc de quantification (506) conçu pour quantifier la différence en fonction du niveau de quantification déterminé ;
- dans lequel une valeur quantifiée obtenue par le bloc de quantification (506) est une valeur quantifiée de l'amplitude des partiels de la trame courante.

6. Appareil selon les revendications 4 ou 5, comprenant en outre une unité de décodage d'amplitude de partiel (502) conçue pour décoder la valeur quantifiée des partiels de la trame courante émise par l'unité de quantification (504) en fonction du niveau de quantification.

7. Appareil selon la revendication 6, dans lequel l'unité de décodage d'amplitude de partiel (502) est conçue pour quantifier inversement la valeur quantifiée, et stocke dans l'unité de stockage (501) un résultat de l'addition de l'amplitude quantifiée inversement des partiels de la trame précédente, qui est lue dans l'unité de stockage (501), à la valeur quantifiée inversement obtenue par la quantification inverse.

8. Appareil selon la revendication 6, dans lequel l'unité de détermination de niveau de quantification (503) est conçue de manière à déterminer le niveau de quantification de sorte que le niveau de quantification change avec une fréquence.

9. Appareil selon la revendication 6, dans lequel l'unité de quantification (504) est conçue pour quantifier la différence en fonction d'une opération consistant à diviser la différence entre l'amplitude des partiels de la trame courante et l'amplitude quantifiée inversement des partiels de la trame précédente, par le niveau de quantification.

10. Procédé de décodage audio d'une amplitude de partiels, lequel procédé consiste à :
- détecter une valeur quantifiée de partiels d'une trame courante à partir d'un signal déformaté de flux binaire ;
- obtenir une amplitude quantifiée inversement de partiels d'une trame précédente ;
- déterminer un niveau de quantification en fonction de l'amplitude quantifiée inversement des partiels de la trame précédente ; et
- quantifier inversement la valeur de quantification détectée en fonction du niveau de quantification déterminé ;
- **caractérisé en ce que** l'on obtient l'amplitude quantifiée inversement des partiels de la trame précédente par les étapes consistant à :
- quantifier inversement une valeur quantifiée des partiels de la trame précédente ; et
- ajouter une amplitude quantifiée inversement de partiels d'une trame précédant la trame précédente à la valeur quantifiée inversement obtenue par la quantification inverse, ceci de manière à obtenir l'amplitude quantifiée inversement des partiels de la trame précédente.

11. Procédé selon la revendication 10, dans lequel la quantification inverse de la valeur de quantification détectée consiste à :
- obtenir une valeur quantifiée inversement des partiels de la trame courante en fonction de la valeur quantifiée et du niveau de quantification ; et
- obtenir une amplitude quantifiée inversement des partiels de la trame courante en fonction de la valeur quantifiée inversement et de l'amplitude quantifiée inversement des partiels de la trame précédente.

12. Appareil (900) pour le décodage audio d'une amplitude de partiels, lequel appareil comprend :
- une unité de détection de valeur quantifiée (902) conçue pour détecter une valeur quantifiée de partiels d'une trame courante à partir d'un signal déformaté de flux binaire ;
- une unité de stockage (903) conçue pour stocker une amplitude quantifiée inversement de partiels d'une trame précédente ;
- une unité de détection de niveau de quantification (904) conçue pour détecter un niveau de quantification en fonction de l'amplitude quantifiée inversement des partiels de la trame précédente ; et
- une unité de quantification inverse (905) conçue pour quantifier inversement la valeur de quantification détectée par l'unité de détection de valeur de quantification en fonction du niveau de quantification détecté par l'unité de détection de niveau de quantification (904) ;
- **caractérisé en ce que** l'unité de quantification inverse (905) est conçue pour :
- quantifier inversement une valeur quantifiée des partiels de la trame précédente ; et
- ajouter une amplitude quantifiée inversement de partiels d'une trame précédant la trame précédente à la valeur quantifiée inversement obtenue par la quantification inverse, ceci de manière à obtenir l'amplitude quantifiée inversement des partiels de la trame précédente.

13. Appareil selon la revendication 12, dans lequel l'unité de quantification inverse (905) comprend :
- un bloc de quantification inverse (906) conçu pour quantifier inversement la valeur quantifiée détectée par l'unité de détection de valeur de quantification (907) en fonction du niveau de quantification ; et
- une unité de détection d'amplitude quantifiée inversement conçue pour détecter une amplitude quantifiée inversement des partiels de la trame courante en fonction de la valeur quantifiée inversement et de l'amplitude quantifiée inversement des partiels de la trame précédente ;
- dans lequel l'amplitude quantifiée inversement des partiels de la trame courante, qui est détectée par l'unité de détection d'amplitude quantifiée inversement (907), est stockée dans l'unité de stockage (903).
